# EUROPEAN PATENT SPECIFICATION

(11) **EP 3 309 960 B1**
(45) Date of publication and mention of the grant of the patent: **21.08.2019**
(21) Application number: 16306357.1
(22) Date of filing: 14.10.2016
(51) Int. Cl.: H03F 1/02, H03F 1/32, H03F 3/193

(54) **AMPLIFICATION SYSTEM AND ENODEB**
VERSTÄRKUNGSSYSTEM UND ENODEB
SYSTÈME D'AMPLIFICATION ET ENODEB

(43) Date of publication of application: 18.04.2018
(73) Proprietor: Nokia Technologies Oy, 02610 Espoo (FI)
(72) Inventor: DARTOIS, Luc, 91620 NOZAY (FR); WANTIEZ, Eric, 91620 NOZAY (FR)
(74) Representative: Nokia EPO representatives

(56) References cited:
- US-A1- 2003 027 535
- US-A1- 2005 277 391
- US-A1- 2012 299 659
- US-B1- 6 556 629
- SEN S ET AL: "Concurrent PAR and power amplifier adaptation for power efficient operation of WiMAX OFDM transmitters", RADIO AND WIRELESS SYMPOSIUM, 2008 IEEE, IEEE, PISCATAWAY, NJ, USA, 22 January 2008 (2008-01-22), pages 21-24, XP031237088, ISBN: 978-1-4244-1462-8

## Description

### FIELD OF INVENTION

The present subject matter relates to an amplification system. For example, this amplification system can be used within a base station or an eNodeB.

### BACKGROUND

Base station sites are the main energy consumers in a mobile network and Radio Frequency (RF) Power Amplifier (PA) consumes more than 50% of the eNodeB total energy, contributing significantly to greenhouse gas (CO2) emissions and operator operational expenses (OPEX). The power amplifier is made of one or several transistors, matching network, combining network, bias circuit, etc. and as per defined architectures aiming to balance linearity as required by 3GPP standard and efficiency. Many power amplifier architectures have been considered. Today two way Doherty power amplifier is the most mature architecture providing with high efficiency performances but only over 6dB dynamic range (9dB for three way Doherty) to address LTE envelop defined by Peak Average Ratio (PAR) at maximum power level. Doherty power amplifier architecture is then optimized for full power while LTE covers much larger dynamic range, linked to the cell load range [0 - 100%].

The state of the art amplification systems, for example using Doherty architecture, have been optimized mostly for high load while average daily load in networks today and still for years to come is quite low (5 to 30%), and so these systems don't solve the problem solve by the present subject matter.

It is also known to adapt the amplification system at macroscopic level, like long term time based switch on and off (day/night) over several cellular standards to keep just the one ensuring coverage with the minimum capacity, switching off some layers at night like small cells clusters or in given standard switching off some carriers and at same time reconfiguring cell maximum power & fixed biasing to reduce peak consumption. This solution doesn't solve allow the adaptation of the amplification system to fast varying power of the signal.

In 4G LTE and in some other standards, true null symbols can be transmitted when no traffic exist. It is known amplification system in which, modem assisted apparatus or standalone apparatus detects zeros and stop power amplifier biasing during those null symbols to optimize consumption. However, when load is not null but only below 100% of maximum transmitter power this solution can not improve the efficiency of the amplification system.

It is also known the US patent reference US 6'556'629.

### SUMMARY

This summary is provided to introduce concepts related to amplification system and to equipment, for example eNodeB comprising this amplification system.

In one implementation an amplification system is described. This amplification system comprises: a crest factor reduction module configured to clip an input signal and at least one power amplifier configured to amplify the clipped signal and a drain bias controller, providing a drain bias voltage to the power amplifier and a gate bias controller, providing a gate bias voltage to the power amplifier and a controller module. Furthermore, within this amplification system, the controller module is configured to use an information parameters of the input signal to control clipping parameters of the crest factor reduction module and the drain bias controller and the gate bias controller.

In another implementation a eNodeB is described. This eNodeB comprises the amplification system presented in the previous section.

### BRIEF DESCRIPTION OF THE FIGURES

The detailed description is given with reference to the accompanying figures. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and with reference to the accompanying figures, in which:

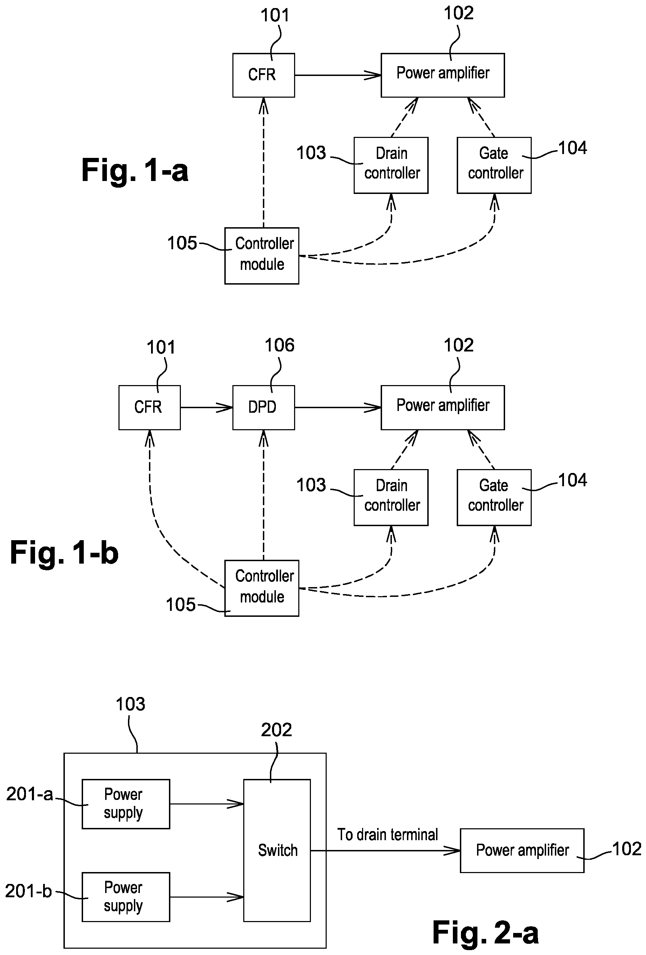

Figure 1-a presents an exemplary amplification system.
Figure 1-b presents an embodiment of the invention.
Figure 2-a presents an embodiment of the drain bias controller

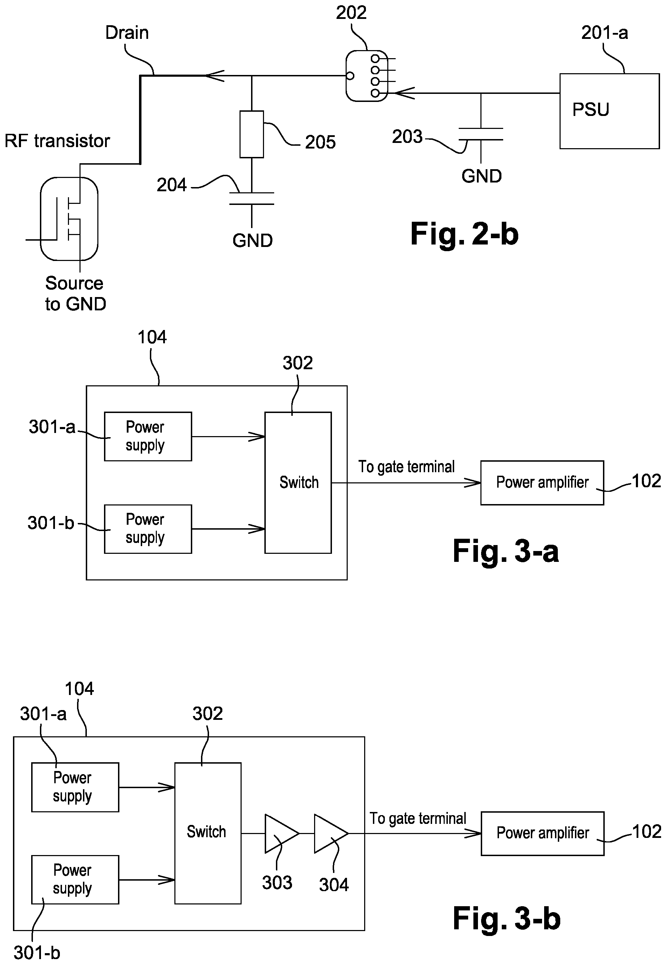

Figure 2-b presents another embodiment of the drain bias controller
Figure 3-a presents a first embodiment of the gate bias controller
Figure 3-b presents a second embodiment of the gate bias controller

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

### DESCRIPTION OF EMBODIMENTS

The figure 1-a presents an exemplary amplification system. This amplification system comprises:
- a crest factor reduction module 101 configured to clip an input signal
- at least one power amplifier 102 configured to amplify the clipped signal and
- a drain bias controller 103, providing a drain bias voltage to the power amplifier; and
- a gate bias controller 104, providing a gate bias voltage to the power amplifier and
- a controller module 105 and
   within this amplification system;
- the controller module 105 being configured to use an information representing parameters of the input signal to control:
   ∘ clipping parameters of the crest factor reduction module 101 and
   ∘ the drain bias controller 103 and
   ∘ the gate bias controller 104.

The figure 1-b presents a first embodiment. This amplification system also comprises:
- a digital pre-distortion module 106 configured to pre-distort the input signal; and the controller module 105 is also configured to use the information representing parameters of the input signal to control the digital pre-distortion module 106.

The aim of the digital pre-distortion module 106 is to linearize nonlinear power amplifier. For example, when the power amplifier is closed to saturation point, power amplifier output amplitude grows less than amplitude input (then power amplifier gain is decreasing). In this case the role of the digital pre-distortion module is then to boost the power of the input signal in order to compensate the power amplifier gain decrease.

The controller module 105 embeds function linked to traffic load and modulation. As output it delivers power amplifier drain bias voltage command (at destination of the drain bias controller 103) according to some predefined rules. The controller module 105 also delivers power amplifier gate voltage command (at destination of the gate bias controller 104) according to some predefined rules.

In an embodiment the parameters of the input signal are the load factor and/or the modulation of the input signal. Load factor here means cell load (0 to 100%), i.e. the ratio between instantaneous usage of the cell and maximum resource available to the cell (for example 20% means 20 Radio blocks allowed versus max 100 Radio Block available with one 20MHz LTE carrier). In LTE, there is no downlink power control, then meaning radio frequency power level of the signal emitted by the eNodeB or base station is directly proportional to load factor.

In an embodiment the crest factor reduction module 101 is adapted to realize a crest factor reduction algorithm (CFR) for example the one described within the patent application EP2485447.

The figure 2-a presents an embodiment of the drain bias controller 103. In this embodiment the drain bias controller 103 comprises:
- at least two voltage power supplies 201-a & 201-b and
- a switch 202 configured to switch a connection of a drain terminal of the power amplifier 102 to one of the different power supplies 201-a or 201-b.

In other word the basic idea is to use a reduced bank of power supplies units (PSU) corresponding to RF transistor power amplifier drain biasing points tuned each for an optimal energy consumption for a given load and dynamically adapt those power supplies units voltages and biasing points according to local cell usage even if usage is moving over time because the adaptive tuning values are set and modified by tracking the statistics and distribution of load.

Figure 2-b presents a further embodiment of the drain bias controller 103, this drain bias controller 103 also comprises;
- a first capacitor 203 with a terminal of this first capacitor connected to a point of a first line going from the power supply to the switch and another terminal of the first capacitor is connected to the ground and
- a second capacitor 204 with a terminal of this second capacitor connected to a point of a second line going from the drain terminal of the power amplifier to the switch and another terminal of the second capacitor is connected to the ground and
- A resistance 205, connected between the second capacitor 204 and the second line.
Within this embodiment the first capacitor 203 acts as primary energy reserve with a capacity of some hundreds of µF. A secondary energy reserve is made of the second capacitor 204 with a capacity of few tens of µF associated to the resistance 205 that is less that few ohms.

In a further embodiment of the drain controller 103, this drain controller 103 is configured:
- to compare a current load factor of the input signal and/or a modulation of the input signal to a previous load factor of the input signal and/or a modulation of the input signal and
- if the current load factor of the input signal is increase or decrease by a ratio above a predefined threshold, from the previous load factor of the input signal to change a voltage output of at least one of the voltage power supplies 201-a or 201-b.

In an embodiment this predefined threshold is comprise within the range 5% to 30% meaning that if the current load factor is 5% to 30% bigger than the previous load factor, then the drain controller 103 will increase the voltage of at least one of the power supply. In the same way if the current load factor is 5% to 30% smaller than the previous load factor, then the drain controller 103 will decrease the voltage of at least one of the power supply.

In an embodiment this predefined threshold depends of:
- how many power supply is in place Ex: high number of power supply with high reconfiguration time allows fine steps,
- how is the ration between power supply reconfiguration time (slew rate) and scheduler cycle (10ms in 4G, less in 5G) ? Ex: 2 power supply with very high low reconfiguration time allows fine steps,
- how is the average load? today average networks load is low meaning it make sense to plan fine step closed to average load, and large step elsewhere.
- how is the burstyness of the load Ex: 2 power supply with very high reconfiguration time AND very low burstyness allows fine steps,

In an embodiment this modification of the tension can be done either very slowly thanks to self-optimizing network (SON) which aims to re-adjust the Base Station RF parameters based on mobiles RF measurements, or much better to do it more quickly assisted by modem sending the load of each carrier or by self-load detection in each cell/radio head.

By using high speed adapted power supply voltages and corresponding load threshold one can better tune the needs and reduce energy consumption as what counts is the aggregated gain over the long periods but also reducing the number of equipment of the amplification system and complexity by reducing total number of power supplies in the bank by fewer where all or some are tunable. The speed of power supply tuning can then be reduced to one period of resource scheduling, 1ms for LTE or 2ms for 3G.

In an embodiment the drain bias controller 102 is configured to change the voltage output of at least one of the voltage power supplies based on a lock up table containing a relation between load factors and/or modulations and tension outputs.

In other words, for each power supply, the voltage is selected for optimal biasing on a given range/segment of load of the power amplifier. Each voltage corresponds to optimal (minimal) voltage to properly amplify with good linearity an average power or load% corresponding to upper load percentage of the segment and is defined to pass corresponding RMS average power plus highest peaks of signal envelope.

The figure 3-a presents a first embodiment of the gate bias controller 104. In this embodiment the gate bias controller 104 comprises;
- at least two voltage power supplies 301-a & 301-b and
- a switch configured to switch a connection of a gate terminal of the power amplifier 102 to one of the different voltage power supplies 301-a or 301-b.

The figure 3-b presents a second embodiment of the gate bias controller 104. In this second embodiment and compare to the first embodiment the gate bias controller 104 further comprises;
- a high gain medium speed buffer 303, with the input terminal of this high gain medium speed buffer connected to the switch with the output terminal of this high gain medium speed buffer connecter to
- a follower medium speed buffer 304, with the input terminal of this follower medium speed buffer connected to the output terminal of the high gain medium speed buffer and the output terminal of this follower medium speed buffer connected to the drain terminal of the power amplifier.
The aim of the high gain medium speed buffer 303 is to amplify the gate bias voltage. The aim of the follower medium speed buffer 304 is to do isolation between the power amplifier and the gate bias controller 104 so this buffer as an amplification ratio of one.

In a further embodiment of the gate bias controller 104, this gate bias controller 104 is configured:
- to compare a current load factor of the input signal and/or a modulation of the input signal to a previous load factor of the input signal and/or a modulation of the input signal and
- if the current load factor of the input signal is increase or decrease by a ratio above a predefined threshold, from the previous load factor of the input signal to change a voltage output of at least one of the voltage power supplies 301-a or 301-b.

In an embodiment this predefined threshold is comprise within the range 5% to 30%, meaning that if the current load factor is 5% to 30% bigger than the previous load factor, then the gate controller 104 will increase the voltage of at least one of the power supply. In the same way if the current load factor is 5% to 30% smaller than the previous load factor, then the gate controller 104 will decrease the voltage of at least one of the power supply.

In an embodiment this predefined threshold depends of:
- how many power supply is in place? Ex: high number of power supply with high reconfiguration time allows fine steps,
- how is the ration between power supply reconfiguration time (slew rate) and scheduler cycle (10ms in 4G, less in 5G) ? Ex: 2 power supply with very high low reconfiguration time allows fine steps,
- how is the average load? Today average networks load is low meaning it make sense to plan fine step closed to average load, and large step elsewhere.
- how is the burstyness of the load? Ex: 2 power supply with very high reconfiguration time AND very low burstyness allows fine steps,
- how is the power amplifier response considering a given drain/gate dynamic → depends on technologies with associated parasitic (Cgd/Cds) and gain/efficiency flatness over large bias dynamic (GaN parasitics lower than LDMOS, larger bias dynamic with GaN compared to 28V LDMOS...)

In an embodiment the drain bias controller 103 and the gate bias controller 104 works in a synchronize way to change the drain and bias voltage. Both of these controllers can also be synchronize with the crest factor reduction module 101 especially with the modification of the clipping radius of the crest factor reduction module 101.

In an embodiment the amplification system also comprises an attenuator configured to attenuate the signal, entering within the power amplifier 102, when the drain bias controller 103 changes the drain bias voltage provided to the power amplifier. In another embodiment this attenuator is also configured to attenuate the signal, entering within the power amplifier 102, when the gate bias controller 104 changes the gate bias voltage provided to the power amplifier.

In an embodiment this modification of the tension can be done either very slowly thanks to self-optimizing network (SON) which aims to re-adjust the Base Station RF parameters based on mobiles RF measurements, or much better to do it more quickly assisted by modem sending the load of each carrier or by self-load detection in each cell/radio head.

In other words, in this embodiment the controller module 105 is configured to obtain the parameters of the input signal via an element of a self-optimizing network.

As for the drain 103 controller, by using high speed adapted power supply, within the gate controller 104, voltages and corresponding load threshold one can better tune the needs and reduce energy consumption as what counts is the aggregated gain over the long periods but also reducing the number of equipment of the amplification system and complexity by reducing total number of power supply in the bank by fewer where all or some are tunable. The speed of power supplies tuning can then be reduced to one period of resource scheduling, 1ms for LTE or 2ms for 3G.

In an embodiment the gate bias controller 104 is configured to change the tension output of at least one of the voltage power supplies based on a lock up table containing a relation between load factors and/or modulations and tension outputs.

For the power supplies of both the drain bias controller and gate bias controller the modification of the voltage of these power supplies is based on real time collection of instant load points at each period and build up by fixed periods of time or by sliding time windows the histogram of load% to build a load & biasing curve segmentation. To do this we adapt the segmented/staircase VDD vs load% curve by changing the pivotal points to maximize the average energy reduction for a given prediction period from the predicted load histogram. When new load histogram differs enough from previous one, then some of pivotal points are changed while changing voltages of some power supplies and repopulating accordingly the selection automaton via the lock up table (LUT).

Furthermore, in a further embodiment each power supplies provides a flag when in transition state to a new voltage setting so as not to use it until stabilized. Those flags are added as inputs to the lock up table to complement the strategy of selection: when a power supply is not ready for use then the next higher one is selected to make best trade off. Strategy to only use stable power supplies helps power amplifier to stay on known stable finite states that help digital pre-distortion module modeling and spectral quality.

In a further embodiment when several power supplies need to be retuned, it's done one by one to maximize the available power supply set and minimize the over biasing during this reconfiguration period.

One embodiment of the present subject matter is an eNodeB. This ENodeB comprises the amplification system according to any of the previous claims.

In another embodiment this ENodeB also comprises a Base Band Unit (BBU) including a modem, and a Radio Module comprising the amplification system.

## Claims

1. Amplification system comprising:
• a crest factor reduction module (101) configured to clip an input signal and to provide a clipped signal and
• at least one power amplifier (102) and
• a drain bias controller (103), providing a drain bias voltage to the power amplifier (102); and
• a gate bias controller (104), providing a gate bias voltage to the power amplifier (102) and
• a controller module (105) and
within this amplification system;
• the controller module (105) being configured to use an information parameters of the input signal to control:
∘ clipping parameters of the crest factor reduction module (101) and
∘ the drain bias controller (103) and
∘ the gate bias controller (104).
the amplification system being **characterized in that** it also comprises:
• a digital pre-distortion module (106) configured to pre-distort the clipped signal;
the at least one power amplifier (102) being configured to amplify the pre-distorted clipped signal; the controller module (105) being also configured to use an information representing parameters of the input signal to control the digital pre-distortion module (106).

2. Amplification system according to any of the previous claims wherein the drain bias controller (103) comprises:
• at least two voltage power supplies (201-a & 201-b) and
• a switch (202) configured to switch a connection of a drain terminal of the power amplifier (102) to one of the voltage power supplies (201-a or 201-b).

3. Amplification system according to the claim 2 wherein the drain bias controller (103) also comprises;
• a first capacitor (203) with a terminal of this first capacitor connected to a point of a first line going from the power supply to the switch and another terminal of the first capacitor (203) is connected to the ground and
• a second capacitor (204) with a terminal of this second capacitor connected to a point of a second line going from the drain terminal of the power amplifier to the switch and another terminal of the second capacitor is connected to the ground and
• A resistance (205), connected between the second capacitor (204) and the second line.

4. Amplification system according to the claim 2 or 3 wherein the parameters of the input signal are the load factor of the input signal and the drain bias controller (103) is configured
• to compare a current load factor of the input signal to a previous load factor of the input signal and
• if the current load factor of the input signal is increase or decrease by a ratio above a predefined threshold, from the previous load factor of the input signal, to change a voltage output of at least one of the voltage power supplies (201-a or 201-b).

5. Amplification system according to the claim 2 or 3 wherein the parameters of the input signal are the load factor and/or a modulation of the input signal and the drain bias controller (103) is configured:
• to change a voltage output of at least one of the voltage power supplies based on a lock up table containing a relation between load factors and/or modulations and voltage outputs and/or
• to change, via the switch (202), the voltage power supplies (201-a or 201-b) connected to the drain terminal of the power amplifier (102), based on a lock up table containing relations between load factors and/or modulations and voltage outputs.

6. Amplification system according to the claims 5 wherein at least one of the voltage power supplies (201-a & 201-b) is configured to set a flag when in transition state to a new voltage output and
the drain bias controller (103) is configured to not connect the voltage power supplies with the flag set to the drain terminal of the power amplifier (102).

7. Amplification system according to any of the previous claims wherein the gate bias (104) controller comprises;
• at least two voltage power supplies (301-a & 301-b) and
• a switch configured to switch a connection of a gate terminal of the power amplifier (102) to one of the different voltage power supplies (301-a or 301-b).

8. Amplification system according to the claim 7 wherein the gate bias controller (104) also comprises:
• a high gain medium speed buffer (303), with the input terminal of this high gain medium speed buffer connected to the switch with the output terminal of this high gain medium speed buffer connecter to
• a follower medium speed buffer (304), with the input terminal of this follower medium speed buffer connected to the output terminal of the high gain medium speed buffer and the output terminal of this follower medium speed buffer connected to the drain terminal of the power amplifier.

9. Amplification system according to the claim 7 or 8 wherein the parameters of the input signal are the load factor of the input signal and the gate bias controller (104) is configured
• to compare a current load factor of the input signal to a previous load factor of the input signal and
• if the current load factor of the input signal is increase or decrease by a ratio above a predefined threshold, from the previous load factor of the input signal to change a voltage output of at least one of the voltage power supplies (301-a or 301-b).

10. Amplification system according to the claim 7 or 8 wherein the parameters of the input signal are the load factor and/or a modulation of the input signal and the gate bias controller (104) is configured:
• to change the voltage output of at least one of the voltage power supplies based on a lock up table containing a relation between load factors and/or modulations and voltage outputs and/or
• to change, via the switch (302), the voltage power supplies (301-a or 301-b) connected to the gate terminal of the power amplifier (102), based on a lock up table containing relations between load factors and/or modulations and voltage outputs.

11. Amplification system, according to claim any of the previous claims, wherein the controller module (105) is configured to obtain the parameters of the input signal via an element of a self-optimizing network.

12. eNodeB comprising the amplification system according to any of the previous claims.

13. eNodeB according to the claim 12 also comprising
• a Base Band Unit (BBU) including a modem, and
• a Radio Module comprising the amplification system.

## Patentansprüche

1. Verstärkungssystem, umfassend:
• ein Scheitelfaktorreduktionsmodul (101), das konfiguriert ist, um ein Eingangssignal zu begrenzen und ein begrenztes Signal bereitzustellen, und
• mindestens einen Leistungsverstärker (102), und
• eine Drain-Vorspannungssteuerung (103), um dem Leistungsverstärker (102) eine Drain-Vorspannung bereitzustellen; und
• eine Gate-Vorspannungssteuerung (104), um dem Leistungsverstärker (102) eine Gate-Vorspannung bereitzustellen; und
• ein Steuerungsmodul (105); und
wobei innerhalb dieses Verstärkungssystems
• das Steuerungsmodul (105) konfiguriert ist, um eine Informationsparameter des Eingangssignals zu verwenden, um folgendes zu steuern:
∘ Begrenzungsparameter des Scheitelfaktorreduktionsmoduls (101) und
∘ die Drain-Vorspannungssteuerung (103) und
∘ die Gate-Vorspannungssteuerung (104),
wobei das Verstärkungssystem **dadurch gekennzeichnet ist, dass** es ferner ebenfalls umfasst:
• ein digitales Vorverzerrungsmodul (106), das konfiguriert ist, um das begrenzte Signal vorzuverzerren;
wobei der mindestens ein Leistungsverstärker (102) konfiguriert ist, um das vorverzerrte begrenzte Signal zu verstärken;
das Steuerungsmodul (105) auch konfiguriert ist, um Informationsrepräsentationsparameter des Eingangssignals zu verwenden, um das digitale Vorverzerrungsmodul (106) zu steuern.

2. Verstärkungssystem nach einem der vorhergehenden Ansprüche, wobei die Drain-Vorspannungssteuerung (103) umfasst:
• mindestens zwei Spannungsleistungsversorgungen (201-a und 201-b), und
• einen Schalter (202), der konfiguriert ist, um eine Verbindung einer Drain-Klemme des Leistungsverstärkers (102) auf eine der Spannungsleistungsversorgungen (201-a oder 201-b) zu schalten.

3. Verstärkungssystem nach Anspruch 2, wobei die Drain-Vorspannungssteuerung (103) ebenfalls umfasst:
• einen ersten Kondensator (203), wobei eine Klemme dieses ersten Kondensators mit einem Punkt einer ersten Leitung verbunden ist, die von der Leistungsversorgung zu dem Schalter verläuft, und eine andere Klemme des ersten Kondensators (203) mit der Erdung verbunden ist, und
• einen zweiten Kondensator (204), wobei eine Klemme dieses zweiten Kondensators mit einem Punkt einer zweiten Leitung verbunden ist, die von der Drain-Klemme des Leistungsverstärkers zu dem Schalter verläuft, und eine andere Klemme des zweiten Kondensators mit der Erdung verbunden ist, und
• einen Widerstand (205), der zwischen dem zweiten Kondensator (204) und der zweiten Leitung verbunden ist.

4. Verstärkungssystem nach den Ansprüchen 2 oder 3, wobei die Parameter des Eingangssignals der Lastfaktor des Eingangssignals sind, und die Drain-Vorspannungssteuerung (103) konfiguriert ist,
• um einen aktuellen Lastfaktor des Eingangssignals mit einem früheren Lastfaktor des Eingangssignals zu vergleichen, und
• um, falls der aktuelle Lastfaktor des Eingangssignals um ein Verhältnis oberhalb eines vordefinierten Schwellenwerts gegenüber dem früheren Lastfaktor des Eingangssignals erhöht oder abgesenkt ist, eine Spannungsausgabe der mindestens einen der Spannungsleistungsversorgungen (201-a oder 201-b) zu ändern.

5. Verstärkungssystem nach den Ansprüchen 2 oder 3, wobei die Parameter des Eingangssignals der Lastfaktor und/oder eine Modulation des Eingangssignals sind, und die Drain-Vorspannungssteuerung (103) konfiguriert ist,
• um eine Spannungsausgabe von mindestens einer der Spannungsleistungsversorgungen basierend auf einer Nachschlagtabelle zu ändern, die eine Beziehung zwischen Lastfaktoren und/oder Modulationen und Spannungsausgaben enthält, und/oder
• um über den Schalter (202) die Spannungsleistungsversorgungen (201-a oder 201-b), die mit der Drain-Klemme des Leistungsverstärkers (102) verbunden sind, basierend auf einer Nachschlagtabelle zu ändern, die Beziehungen zwischen Lastfaktoren und/oder Modulationen und Spannungsausgaben enthält.

6. Verstärkungssystem nach Anspruch 5, wobei mindestens eine der Spannungsleistungsversorgungen (201-a und 201-b) konfiguriert ist, um ein Flag zu setzen, wenn es im Übergangszustand zu einer neuen Spannungsausgabe ist, und
die Drain-Vorspannungssteuerung (103) konfiguriert ist, um die Spannungsleistungsversorgungen, bei denen das Flag gesetzt ist, nicht mit der Drain-Klemme des Leistungsverstärkers (102) zu verbinden.

7. Verstärkungssystem nach einem der vorhergehenden Ansprüche, wobei die Gate-Vorspannungssteuerung (104) umfasst:
• mindestens zwei Spannungsleistungsversorgungen (301-a und 301-b), und
• einen Schalter, der konfiguriert ist, um eine Verbindung einer Gate-Klemme des Leistungsverstärkers (102) auf eine der verschiedenen Spannungsleistungsversorgungen (301-a oder 301-b) zu schalten.

8. Verstärkungssystem nach Anspruch 7, wobei die Gate-Vorspannungssteuerung (104) ebenfalls umfasst:
• einen High-Gain-Puffer (303) mit mittlerer Geschwindigkeit, wobei die Eingangsklemme dieses High-Gain-Puffers mit mittlerer Geschwindigkeit mit dem Schalter verbunden ist, und die Ausgabeklemme dieses Steckers des High-Gain-Puffers mit mittlerer Geschwindigkeit verbunden ist mit
• einem folgenden Puffer (304) mit mittlerer Geschwindigkeit, wobei die Eingangsklemme dieses folgenden Puffers mit mittlerer Geschwindigkeit mit der Ausgabeklemme des High-Gain-Puffers mit mittlerer Geschwindigkeit verbunden ist und die Ausgabeklemme dieses folgenden Puffers mit mittlerer Geschwindigkeit mit der Drain-Klemme des Leistungsverstärkers verbunden ist.

9. Verstärkungssystem nach den Ansprüchen 7 oder 8, wobei die Parameter des Eingangssignals der Lastfaktor des Eingangssignals sind, und die Gate-Vorspannungssteuerung (104) konfiguriert ist,
• um einen aktuellen Lastfaktor des Eingangssignals mit einem früheren Lastfaktor des Eingangssignals zu vergleichen, und
• um, falls der aktuelle Lastfaktor des Eingangssignals durch ein Verhältnis oberhalb eines vordefinierten Schwellenwerts gegenüber dem früheren Lastfaktor des Eingangssignals erhöht oder abgesenkt wird, eine Spannungsausgabe der mindestens einen der Spannungsleistungsversorgungen (301-a oder 301-b) zu ändern.

10. Verstärkungssystem nach den Ansprüchen 7 oder 8, wobei die Parameter des Eingangssignals der Lastfaktor und/oder eine Modulation des Eingangssignals sind, und die Gate-Vorspannungssteuerung (104) konfiguriert ist,
• um die Spannungsausgabe von mindestens einer der Spannungsleistungsversorgungen basierend auf einer Nachschlagtabelle zu ändern, die eine Beziehung zwischen Lastfaktoren und/oder Modulationen und Spannungsausgaben enthält, und/oder
• um über den Schalter (302) die Spannungsleistungsversorgungen (301-a oder 301-b), die mit der Gate-Klemme des Leistungsverstärkers (102) verbunden sind, basierend auf einer Nachschlagtabelle zu ändern, die Beziehungen zwischen Lastfaktoren und/oder Modulationen und Spannungsausgaben enthält.

11. Verstärkungssystem nach einem der vorhergehenden Ansprüche, wobei das Steuerungsmodul (105) konfiguriert ist, um die Parameter des Eingangssignals über ein Element eines selbstoptimierenden Netzwerks zu erhalten.

12. eNodeB, umfassend das Verstärkungssystem gemäß einem der vorhergehenden Ansprüche.

13. eNodeB nach Anspruch 12, ebenfalls umfassend:
• eine Basisbandeinheit (BBU), die ein Modem einschließt, und
• ein Funkmodul, welches das Verstärkungssystem umfasst.

## Revendications

1. Système d'amplification comprenant :
• un module de réduction du facteur de crête (101) configuré pour écrêter un signal d'entrée et pour fournir un signal écrêté et
• au moins un amplificateur de puissance (102) et
• un dispositif de contrôle de la polarisation du drain (103), fournissant une tension de polarisation du drain à l'amplificateur de puissance (102) ; et
• un dispositif de contrôle de la polarisation de la grille (104), fournissant une tension de polarisation de la grille à l'amplificateur de puissance (102) et
• un module de dispositif de contrôle (105) et
au sein de ce système d'amplification :
• le module de dispositif de contrôle (105) étant configuré pour utiliser une information représentant des paramètres du signal d'entrée afin de contrôler :
∘ les paramètres d'écrêtage du module de réduction du facteur de crête (101) et
∘ le dispositif de contrôle de la polarisation du drain (103) et
∘ le dispositif de contrôle de la polarisation de la grille (104)
le système d'amplification étant **caractérisé en ce qu'**il comprend en outre :
• un module de pré-distorsion numérique (106) configuré pour appliquer une pré-distorsion au signal écrêté ;
l'au moins un amplificateur de puissance (102) étant configuré pour amplifier le signal écrêté pré-distordu ;
le module de dispositif de contrôle (105) étant également configuré pour utiliser une information représentant des paramètres du signal d'entrée pour contrôler le module de pré-distorsion numérique (106).

2. Système d'amplification selon l'une quelconque des revendications précédentes, dans lequel le dispositif de contrôle de la polarisation du drain (103) comprend :
• au moins deux alimentations électriques en tension (201-a et 201-b) et
• un commutateur (202) configuré pour commuter une connexion d'une borne de drain de l'amplificateur de puissance (102) à l'une des alimentations électriques en tension (201-a ou 201-b).

3. Système d'amplification selon la revendication 2, dans lequel le dispositif de contrôle de la polarisation du drain (103) comprend en outre :
• un premier condensateur (203), une borne de ce premier condensateur étant connectée à un point d'une première ligne allant de l'alimentation électrique au commutateur et une autre borne du premier condensateur (203) est connecté à la masse et
• un second condensateur (204), une borne de ce second condensateur étant connectée à un point d'une seconde ligne allant de la borne de drain de l'amplificateur de puissance au commutateur et une autre borne du second condensateur est connecté à la masse et
• une résistance (205) connectée entre le second condensateur (204) et la seconde ligne.

4. Système d'amplification selon les revendications 2 ou 3, dans lequel les paramètres du signal d'entrée sont le facteur de charge du signal d'entrée et le dispositif de contrôle de polarisation du drain (103) est configuré
• pour comparer un facteur de charge actuel du signal d'entrée à un facteur de charge précédent du signal d'entrée et
• si le facteur de charge actuel du signal d'entrée est augmenté ou diminué d'un rapport supérieur à un seuil prédéfini, à partir du facteur de charge précédent du signal d'entrée, pour modifier une sortie de tension d'au moins une des alimentations électriques en tension (201-a ou 201-b).

5. Système d'amplification selon les revendications 2 ou 3, dans lequel les paramètres du signal d'entrée sont le facteur de charge et/ou une modulation du signal d'entrée et le dispositif de contrôle de la polarisation du drain (103) est configuré :
• pour modifier une sortie de tension d'au moins une des alimentations électriques en tension sur la base d'une table de verrouillage contenant une relation entre les facteurs de charge et/ou les modulations et les sorties de tension et/ou
• pour modifier, par l'intermédiaire du commutateur (202), les alimentations électriques en tension (201-a ou 201-b) connectées à la borne de drain de l'amplificateur de puissance (102), sur la base d'une table de verrouillage contenant des relations entre les facteurs de charge et/ou les modulations et les sorties de tension.

6. Système d'amplification selon la revendication 5, dans lequel au moins l'une des alimentations électriques en tension (201-a et 201-b) est configurée pour définir un indicateur dans un état de transition vers une nouvelle sortie de tension et le dispositif de contrôle de la polarisation du drain (103) est configuré pour ne pas connecter les alimentations électriques en tension lorsque l'indicateur est défini sur la borne de drain de l'amplificateur de puissance (102).

7. Système d'amplification selon l'une quelconque des revendications précédentes, dans lequel le dispositif de contrôle de la polarisation de la grille (104) comprend :
• au moins deux alimentations électriques en tension (301-a et 301-b) et
• un commutateur configuré pour commuter une connexion d'une borne de grille de l'amplificateur de puissance (102) à l'une des alimentations électriques en tension (301-a ou 301-b) différentes.

8. Système d'amplification selon la revendication 7, dans lequel le dispositif de contrôle de la polarisation de la grille (104) comprend en outre :
• une mémoire tampon à vitesse moyenne et à gain élevé (303), la borne d'entrée de cette mémoire tampon à vitesse moyenne et à gain élevé étant connectée au commutateur alors que la borne de sortie de cette mémoire tampon à vitesse moyenne et à gain élevé est connectée à
• une mémoire tampon à suiveur à vitesse moyenne (304), la borne d'entrée de cette mémoire tampon à suiveur à vitesse moyenne étant connectée à la borne de sortie de la mémoire tampon à vitesse moyenne et à gain élevé et la borne de sortie de cette mémoire tampon à suiveur à vitesse moyenne étant connectée à la borne de drain de l'amplificateur de puissance.

9. Système d'amplification selon les revendications 7 ou 8, dans lequel les paramètres du signal d'entrée sont le facteur de charge du signal d'entrée et le dispositif de contrôle de la polarisation du drain (104) est configuré
• pour comparer un facteur de charge actuel du signal d'entrée à un facteur de charge précédent du signal d'entrée et
• si le facteur de charge actuel du signal d'entrée augmente ou diminue d'un rapport supérieur à un seuil prédéfini, à partir du facteur de charge précédent du signal d'entrée pour modifier une sortie de tension d'au moins une des alimentations électriques en tension (301-a ou 301 -b).

10. Système d'amplification selon les revendications 7 ou 8, dans lequel les paramètres du signal d'entrée sont le facteur de charge et/ou une modulation du signal d'entrée et le dispositif de contrôle de la polarisation de la grille (104) est configuré :
• pour modifier la sortie de tension d'au moins une des alimentations électriques en tension sur la base d'une table de verrouillage contenant une relation entre les facteurs de charge et/ou les modulations et les sorties de tension et/ou
• pour modifier, par l'intermédiaire du commutateur (302), les alimentations électriques en tension (301-a ou 301-b) connectées à la borne de grille de l'amplificateur de puissance (102), sur la base d'une table de verrouillage contenant des relations entre les facteurs de charge et/ou les modulations et les sorties de tension.

11. Système d'amplification selon l'une quelconque des revendications précédentes, dans lequel le module de dispositif de contrôle (105) est configuré pour obtenir les paramètres du signal d'entrée par l'intermédiaire d'un élément d'un réseau à optimisation automatique.

12. eNodeB comprenant le système d'amplification selon l'une quelconque des revendications précédentes.

13. eNodeB selon la revendication 12 et comprenant également
• une unité en bande de base (BBU) comprenant un modem, et
• un module radio comprenant le système d'amplification.
